# EUROPEAN PATENT APPLICATION

(11) **EP 1 605 309 A1**
(43) Date of publication of application: **14.12.2005**
(21) Application number: 04102647.7
(22) Date of filing: 10.06.2004
(51) Int. Cl.: G03F 7/16, B41N 1/12, B41N 3/00

(54) **Method and apparatus for the drying of the printing plates for flexography**

(71) Applicant: Degraf S.P.A., 20084 Lacchiarella (IT)
(72) Inventor: De Caria, Riccardo, 20080, Basiglio (IT)
(74) Representative: Gervasi, Gemma

(57) **Abstract**

The present invention provides for an apparatus for the drying step of the printing plates for flexography, so as to let a solvent present inside the plates to evaporate, comprising a base element (9) for carrying the printing plates (8), and a lighting system (1) above the printing plates for heating the printing plates by irradiation of light, preferably in the range of red wavelengths.

## Description

The present invention relates to a method and apparatus for the drying of the printing plates for flexography.

As known, flexography is a printing technique using flexible printing plates preferably made of a photopolimeric material like rubber or plastic. The inked plates with a slightly raised image are rotated on a cylinder which transfers the image to the substrate. Flexography is a high-speed print process, can print on many types of absorbent and non-absorbent materials, and can print continuous patterns (such as for giftwrap and wallpaper).

Some typical applications for flexography are paper and plastic bags, milk cartons, disposable cups, and candy bar wrappers. Flexography printing may also be used for envelopes, labels, and newspapers. It is frequently used for printing on plastic, foil, acetate film, brown paper, and other materials used in packaging.

One of the steps for the printing plates preparation is the plate drying, to allow the solvent, penetrated inside the plate in the previous phases for eliminating the non-etched parts of the plate, to evaporate.

The state of the art for the printing plate drying step is to create a flow of hot air, at a velocity of about 1-1.5 m/s, above the plates, in a plate chamber, to allow the solvent going out of the plate to evaporate due to the plate heating. The temperature of the air is controlled to not go beyond a threshold of 60° C, to avoid permanent deformation of the plates.

The total time needed for the drying step is around one hour for every millimeter of plate thickness. As in the practice the normal plate thickness available on the market ranges from 1.14 to 6.35 mm, the total time needed for the drying step is 1 to 6 hours. This long time is therefore a problem.

The long time is needed for the fact that using hot air for the plate heating renders the temperature of the plate surface higher than inside. Therefore also the tension (pressure) of the solvent is higher on the plate surface than inside, hindering the migration of the solvent from inside the plate to the outside.

In addition a high quantity of hot air is needed, in the range of some thousands m³. The known apparatus for printing plate drying, with more than one extractable box for carrying the plates (i.e. four) need an hot air flow of about 350 m³/h. This also creates a further problem in the cost and difficulty of the embodiment of an air purification system, for recovering the solvent, and avoiding pollution.

Therefore in view of the above mentioned problems, it is the main purpose of the present invention to provide a method and apparatus for the drying step of the printing plates for flexography, which reduces drastically the total time needed, basically by heating the inside of the plate at least at the same temperature than the surface, to allow the solvent to evaporate more rapidly, and also rendering the solvent recovering much easier and cheaper.

The basic idea of the present invention is to heat the printing plates by irradiation of light, preferably in the range of red wavelengths.

The light penetrates the plate which is transparent at these wavelengths and is reflected by the base of the plate. The light is refracted inside the plate heating it inside as well as on the surface. The solvent particles change to the gaseous state and migrate toward the surface rapidly. The migration velocity is such that the plate thickness does not affect the total time needed for drying. Typically a total time of 15/20 min is sufficient for taking all the solvent away, independently from the plate thickness, and given that the temperature is controlled not to go beyond the threshold of 60°C. For example in the use in the packaging sector (printing on corrugated boards) the typical plate thickness is 3 to 6 mm, therefore the saving of time and energy is extremely high. With the present invention the huge flow of hot air is no longer needed. What is needed is only a light flow of low velocity room temperature air, preferably in the range of 0.1 to 0.3 m/s, for taking the solvent vapour emanating from the plates away. The air is someway heated by the hot temperature developed over the plates, which is again around 60°C. Due to the low velocity of the air, the temperature gradient inside the plate chamber is also low, and this is an advantage for the better uniformity of temperature inside the chamber.

A double effect of reduction of the air quantity is obtained: by both reducing the total drying time and the air velocity. This way it is much easier, cheaper and feasible the embodiment of an air purification system to recover the solvent and avoid pollution.

These and further objects are achieved by means of a method and apparatus for the drying step of the printing plates for flexography, as described in the attached claims, which are considered an integral part of the present description.

The invention will become fully clear from the following detailed description, given by way of a mere exemplifying and non limiting example, to be read with reference to the attached drawing figures, wherein:
- Fig. 1 shows a schematic side sectional view of the apparatus for the drying of the printing plates in accordance with the invention;
- Fig. 2 shows another side view of the apparatus, perpendicular to that of fig. 1;
- Fig. 3 shows a top view of the apparatus more specifically showing the lighting system according to the invention;
- Fig. 4 shows the air flow directions in the printing plate chamber.

The same reference numerals and letters in the figures designate the same elements.

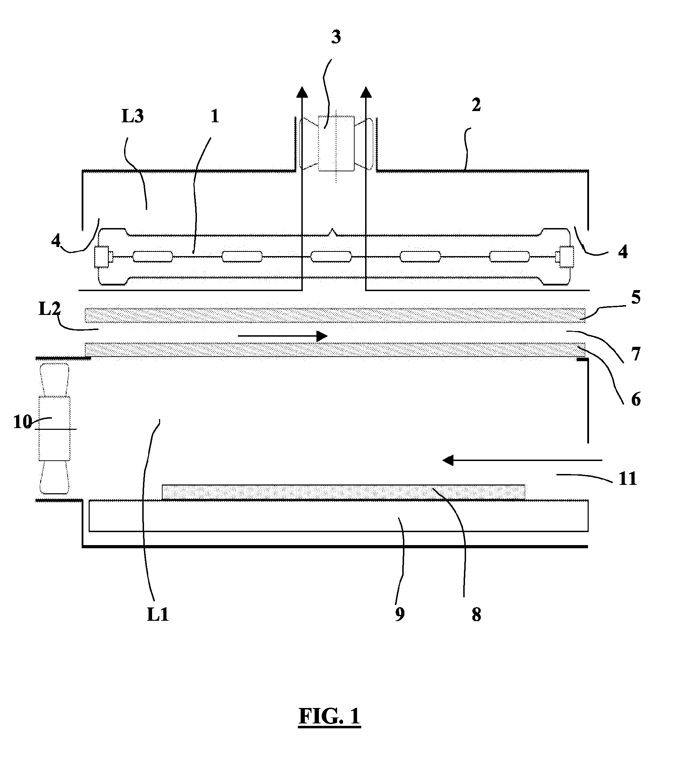

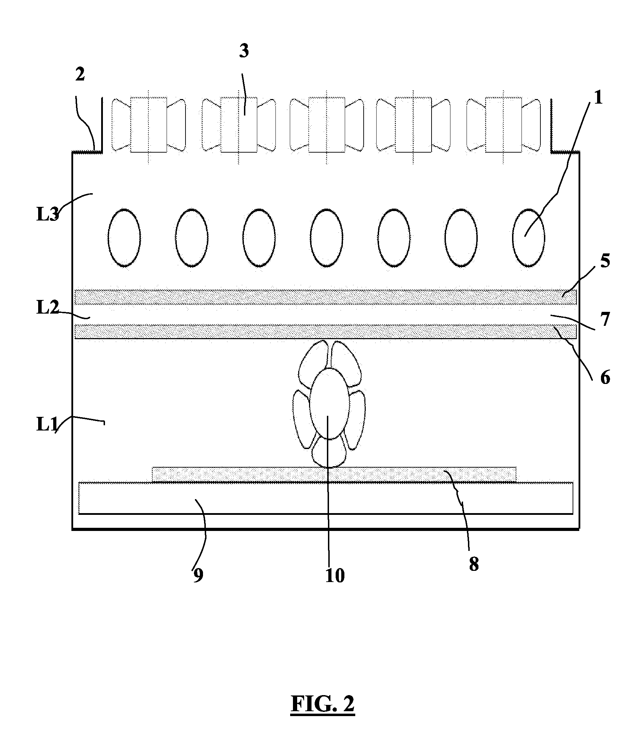

As shown in figures 1 and 2, an apparatus for drying the printing plates comprises the following elements, from the bottom of the figures.

An extractable box comprising a base element 9 for carrying the printing plates 8. Above the printing plates, two interspaced sheets of tempered glass, 5 and 6. Above the glass sheets, a lighting system 1, described in details below, inside a tank for air depression 2.

Suitable fan systems 3 and 10 are also provided for the air circulation, as described below.

The apparatus is divided in three layers, L1, L2 and L3.

The lower layer L1 forms a chamber for the hosting of the printing plates to be dried. An hollow space above the plates 8 is created having the glass sheet 6 as a cap: an air flow is created by air inlet 11 and air outlet where a fan system 10 is located. The arrow shows the air flow direction.

As explained above, a light flow of low velocity room temperature air is created, preferably in the range of 0.1 to 0.5 m/s, for taking the solvent vapour emanating from the plates away. The air is someway heated by the hot temperature developed over the plates, around 60°C. Due to the low velocity of the air, the temperature gradient inside the plate chamber is also low, and this is an advantage for the better uniformity of temperature inside the chamber.

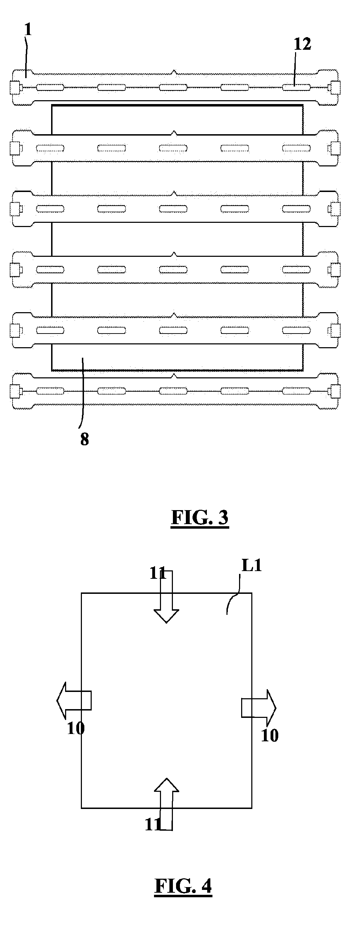

A preferred scheme of air flow in the chamber L1 is as shown in fig. 4, with two air inlets 11 at opposite sides with respect to two air outlets 10. This allows a further reduction of temperature gradient inside the chamber.

An air purification system, not shown in the figures, is connected to the air outlets 10, and can be dimensioned according to the average air flow in the chamber L1. With a drying time of 20 min, a total air flow of 10 m³ is enough.

The air purification system can be of any known type, preferably of the refrigeratory type. This because the solvent includes a volatile component (aliphatic alchool) that can also be completely recovered through a system like this.

The whole of the solvent can be recovered this way, by air condensation. As an example, for a plate of 2 m², a quantity of about 50 cc of solvent is recovered for each millimeter of plate thickness.

The upper layer L3 forms a chamber for the hosting of the lighting system 1. The glass sheet 5 is the floor of the chamber, while the cap is a tank 2 for air depression.

The lighting system 1 must be suitable to the purpose of creating a uniform irradiation of light towards the plates located in the lower layer L1, as all the points of the plate surface must receive the same quantity of light rays, namely the same energy and temperature. The difference in the level of irradiation in the different points of the plate surface 8 has to remain within a range of 6-7 %.

A preferred embodiment of the lighting system is shown in fig. 3. It comprises a number of parallel normal quartz lamps 1, having a particular geometry depending on the distance from the plates, with a preferred emission in the range of red wavelengths (400 - 780 nm), so as to generate heating. An unavoidable parasitic emission in the range of infrared wavelengths is also present, to be eliminated as described below.

Each lamp irradiates with an intensity decreasing more or less linearly with the angle of irradiation; putting the lamps at a relative distance equal to that with respect to the plates, in the different points of the plates the total irradiation is given by the sum of the contributions of two contiguous lamps with a mutual compensation, so giving a uniform level of irradiation in the different points.

Each lamp has a series of lighting sectors 12 with an individual length equal to the distance between them and equal to the distance between the different lamps, so as to form a complete two-dimensional grid of lighting sectors.

In a non limiting example this common distance is 40 mm.

To ensure a uniform lighting level even at the boundaries of the surface to be lighted, the dimensions of the grid of lighting sectors of the lamps exceeds that of the plate surface 8 to be lighted by a value equal to the common distance. In the specific example if the maximum dimension of the plates is 1320 x 2000 mm, the dimensions of the grid of lighting sectors will be 1400 x 2080 mm.

The power supply voltage of the quartz lamps depends on the total length of the lighting sectors of the lamp. Therefore the lamps are so designed as to be supplied by normal existing power supply voltage, for example a three-phase 380 V. In some installations with a considerable total length to be lighted, it is possible to put two or more lamps connected in series, so as each lamp can be still powered by available voltage.

By means of the tank 2 for air depression, a cooling system for the lamps is obtained. A clean room-temperature air, which does not need any purification action, enters the chamber L3 from air inlets 4, makes a cooling action passing through the lamps, and is taken away from the air outlet 3, by a suitable fan system on the cap 2.

The intermediate layer L2 in between the two glass sheets 5 and 6 is created to eliminate the effects of the parasitic infrared emission by the lighting system 1, and transparent to the wanted light wavelengths, which pass through and reach the lower layer L1. The sheet 5 nearer to the lamps reflects a part of infrared emission back towards the lamps; a remaining part of infrared wavelengths is refracted towards the other sheet 6 and reflected back. This remaining part reflects and bounces in the interspace 7 between the two sheets: the relating energy is dissipated by generating heating which is taken away by a suitable air flow. This is a clean room-temperature air which does not need any purification action.

To control the temperature of the printing plate so as not to go beyond the threshold of 60°C, some normal temperature probes not shown in the figures are put near to the plates on the base element 9, so as to regulate the switching (duty-cycle) of the lamps by a suitable state-of-the-art circuitry.

Further implementation details will not be described, as the man skilled in the art is able to carry out the invention starting from the teaching of the above description.

Many changes, modifications, variations and other uses and applications of the subject invention will become apparent to those skilled in the art after considering the specification and the accompanying drawings which disclose preferred embodiments thereof. All such changes, modifications, variations and other uses and applications which do not depart from the spirit and scope of the invention are deemed to be covered by this invention.

## Claims

1. Method for drying printing plates for flexography, so as to let a solvent present inside the plates to evaporate, **characterized in that** it comprises the step of heating the printing plates by irradiation of light, preferably in the range of red wavelengths.

2. Method according to claim 1, **characterized in that** it also comprises the step of letting a flow of air pass over the plates, for taking the solvent vapour emanating from the plates away.

3. Method according to claim 2, **characterized in that** a temperature gradient of the flow of air is controlled by providing one or more air inlets in opposite sides with respect of one or more air outlets.

4. Method according to claim 2, **characterized in that** the flow of air is at low velocity, preferably in the range of 0.1 to 0.3 m/s, and at room-temperature.

5. Method according to claim 2, **characterized in that** said air passing over the plates is brought to an air purification system to recover the solvent.

6. Method according to claim 1, **characterized in that** said irradiation of light is made uniform over the plates.

7. Method according to claim 1, **characterized in that** said irradiation of light is made by a number of quartz lamps put over the printing plates.

8. Method according to claim 7, **characterized in that** said number of quartz lamps is put in a separated layer from the plate layer, by an intermediate layer transparent to the light.

9. Method according to claim 8, **characterized in that** said number of quartz lamps are cooled by a clean room-temperature air flow.

10. Method according to claim 8, **characterized in that** said intermediate layer is able to eliminate a parasitic emission of infrared wavelengths by said quartz lamps, and is cooled by an own cooling air flow.

11. Apparatus for drying printing plates for flexography, so as to let a solvent present inside the plates to evaporate, **characterized in that** it comprises:
- a base element (9) for carrying the printing plates (8);
- a lighting system (1) above the printing plates for heating the printing plates by irradiation of light, preferably in the range of red wavelengths.

12. Apparatus according to claim 11, **characterized in that** said lighting system (1) creates a uniform irradiation of light over the plates, even at the boundaries of the base element.

13. Apparatus according to claim 11, **characterized in that** it further comprises a division layer (L2) between the base element (9) and the lighting system (1).

14. Apparatus according to claim 13, **characterized in that** it further comprises means (10) for creating a light flow of low velocity room temperature air over the plates, for taking the solvent vapour emanating from the plates away.

15. Apparatus according to claim 14, **characterized in that** said flow of low velocity room temperature air is in the range of 0.1 to 0.3 m/s.

16. Apparatus according to claim 14, **characterized in that** said flow of low velocity room temperature air is let flow over the plates by one or more air inlets in opposite sides with respect of one or more air outlets.

17. Apparatus according to claim 14, **characterized in that** it further comprises an air purification system receiving said flow of low velocity room temperature air, for recovering said solvent.

18. Apparatus according to claim 17, **characterized in that** said air purification system is of the refrigeratory type.

19. Apparatus according to claim 12, **characterized in that** said lighting system (1) comprises a number of quartz lamps, with a preferred emission in the range of red wavelengths.

20. Apparatus according to claim 19, **characterized in that** said number of quartz lamps are parallely disposed, at a relative distance equal to that with respect to the plates.

21. Apparatus according to claim 20, **characterized in that** each of said quartz lamps comprises a series of lighting sectors (12) with an individual length equal to the distance between them and equal to the distance between the different lamps, so as to form a complete two-dimensional grid of lighting sectors.

22. Apparatus according to claim 21, **characterized in that** the dimensions of the grid of lighting sectors exceeds that of the plate surface (8) by a value equal to said distance.

23. Apparatus according to claim 13, **characterized in that** said division layer (L2) between the base element (9) and the lighting system (1) comprises two interspaced sheets of tempered glass (5, 6), to eliminate the effects of the parasitic infrared emission by said lighting system (1), and transparent to the light wavelengths.

24. Apparatus according to claim 23, **characterized in that** said division layer (L2) comprises a further cooling system creating an air flow in said interspace.

25. Apparatus according to claim 11, **characterized in that** it further comprises means to control the temperature of the printing plates by regulating the switching (duty-cycle) of said lighting system (1).
